Europäisches Patentamt

(19) European Patent Office

Office européen des brevets

(11) Publication number: **0 197 579**
**B1**

(12) **EUROPEAN PATENT SPECIFICATION**

(45) Date of publication of the patent specification:
08.11.89

(21) Application number: 86200454.6

(22) Date of filing: 20.03.86

(51) Int. Cl.⁴: **H01J 37/065**, H01J 37/04

(54) Electron beam apparatus comprising an integrated anode/beam blanking unit.

(30) Priority: **28.03.85 NL 8500907**

(43) Date of publication of application:
**15.10.86 Bulletin 86/42**

(45) Publication of the grant of the patent:
**08.11.89 Bulletin 89/45**

(84) Designated Contracting States:
**CH DE FR GB LI NL**

(56) References cited:
**EP-A- 0 001 228**
**EP-A- 0 086 431**
**EP-A- 0 156 007**
**DE-A- 2 705 417**

(73) Proprietor: **N.V. Philips' Gloeilampenfabrieken,**
**Groenewoudseweg 1, NL-5621 BA Eindhoven(NL)**

(72) Inventor: **Tolner, Harm, c/o INT. OCTROOIBUREAU B.V.**
**Prof. Holstlaan 6, NL-5656 AA Eindhoven(NL)**
Inventor: **Feuerbam, Hans-Peter, c/o INT.**
**OCTROOIBUREAU B.V. Prof. Holstlaan 6, NL-5656 AA**
**Eindhoven(NL)**

(74) Representative: **Scheele, Edial François et al,**
**INTERNATIONAAL OCTROOIBUREAU B.V. Prof.**
**Holstlaan 6, NL-5656 AA Eindhoven(NL)**

ACTORUM AG

## Description

The invention relates to an electron beam apparatus comprising an electron emitter, a Wehnelt cylinder, an anode, a beam blanking device and an electron-optical system for alignment and modulation of an electron beam to be emitted by the electron emitter.

Such an electron beam apparatus is known in the form of an electron microscope from Philips Technical Review, Vol. 29, 1968, pp. 370-386. In an apparatus described therein a filament or cathode as electron emitter and a Wehnelt cylinder are combined in a customary manner so as to form one unit which will also be referred to as the gun hereinafter. Such a unit is normally mounted in the apparatus so as to be exchangeble as a unity. The Wehnelt cylinder usually is mounted relatively near to the cathode and comprises an aperture wherethrough an electron beam to be emitted by the cathode enters the apparatus. A comparatively small current control voltage difference exists between the Wehnelt cylinder and the cathode during operation. Electrically as well as mechanically an anode of the described apparatus is more or less integral with the electron-optical system thereof and can also be mounted in the apparatus so as to be separately exchangeable. In known apparatus the anode carries a relatively high potential with respect to the potential of the Wehnelt cylinder during operation. Therefore, the anode should be mounted so as to be suitably electrically insulated from the Wehnelt cylinder, which fact resulted in the construction as known in prior art apparatus.

Viewed in the direction of movement of the electron beam, a relevant electron beam apparatus comprises after the anode a beam blanking device for blanking the beam potentially at a high frequency, at least to prevent further penetration of the beam into the apparatus. For this purpose use is customarily made of an electrostatic or electromagnetic beam deflection system which, however, must be distinguished from a possibly present beam alignment system for axial alignment of the beam and a possibly present beam scanning system for imparting a scanning motion to the electron beam over an object to be examined. During the positioning of the cathode-Wehnelt cylinder assembly, the anode and the beam blanking device with respect to one another, problems are often encountered, notably as a consequence of a possible radial shift of the components with respect to one another which especially can occur due to the frequent opening and closing of the apparatus.

It is an object of the invention to mitigate this drawback. To achieve this, an electron beam apparatus of the kind set forth in accordance with the invention is characterized in that the cathode, the Wehnelt cylinder, the anode and the beam blanking device form a mechanically integrated electron optical unit.

Due to the fact that all those devices are rigidly mechanically interconnected in an electron beam apparatus in accordance with the invention, these components can be extremely accurately positioned with respect to one another and their mutual position will not be lost upon removal from the apparatus et. Moreover, removal and hence cleaning of the beam blanking device is substantially simplified. Furthermore, a self-cleaning effect can occur in the device as a result of an improved temperature distribution.

In a further embodiment the gun, the anode and the beam blanking unit are integrated into a unity in a rigid construction and are mounted exchangeable as a unity in the apparatus.

A further electron beam apparatus according to the invention is dedicated to operate with an electron beam having an energy of at the most some KeV. The dimensions of the construction there can be reduced and the precision of the positioning of the relevant elements be increased. In a preferred embodiment the apparatus is dedicated to operate with an electron energy not over about 1 KeV resulting in a further precision and having the advantage of avoiding electrically loading phenomena of the construction materials due to the fact that for this energy the secondary emission coefficient is obvious exactly 1. This is the more attractive because this electron energy is an optimate for semi-conductor device inspection. These devices are not damaged by electrons of that energy and the detection conditions are still relatively good.

Some preferred embodiments in accordance with the invention will be described in detail hereinafter with reference to the drawing. Therein :

Fig. 1 shows an electron microscope comprising an anode/beam blanking unit in accordance with the invention, and

Fig. 2 shows an embodiment of an integrated gun-anode/beam blanking unit for such an apparatus.

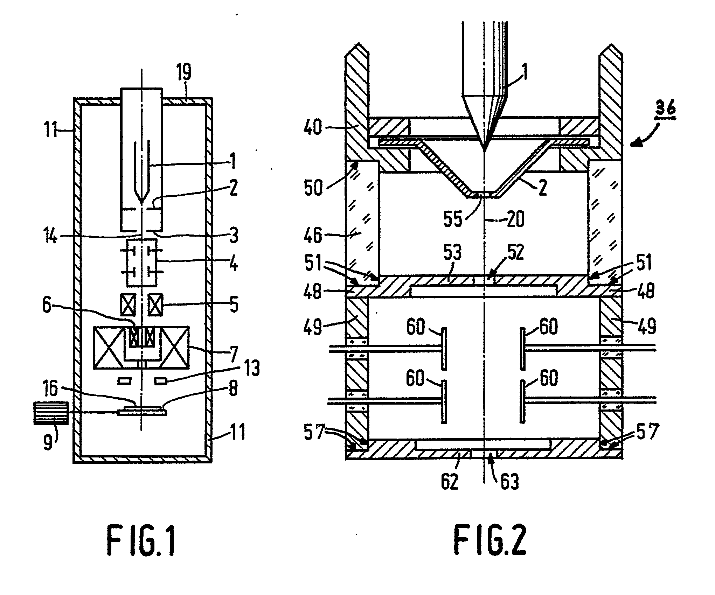

An electron microscope as shown in Fig. 1 comprises a cathode 1, a Wehnelt cylinder electrode 2, an anode 3, a beam blanking device 4, a beam scanning system 5, a beam alignment system 6 and a final lens 7 and a specimen stage 8 with a specimen adjustment device 9. All said elements are accomodated in a housing 11 which also comprises a detection system 13. With an electron beam 14, to be emitted by the cathode, a specimen 16 arranged on the specimen carrier can be irradiated and radiation due to interaction with the specimen can be detected. In a scanning electron microscope the specimen is scanned by the electron beam and transmitted, reflected and/or secondary electrons or other radiation generated by interaction beween the electron beam and the object can be detected by the detector system 16 to which a television monitor system, not shown in the drawing, is connected.

In the embodiment as presented the cathode and the Wehnelt cylinder are combined in a cathode Wehnelt unit or electron gun. This unit may be connected, for example to a closing plate, being removable from the apparatus together therewith. This can also be realized by means of a hinged construction. The electron gun, the anode and the beam blanking device are in accordance with the invention combined in a mechanically integrated electron optical unit (36). This unit is mounted in the housing of the apparatus so as to be exchangeable, using an intermediate ring which adjoins the hinge opening in the wall of the housing. The intermediate piece is preferably mounted so that it is not taken along when the gun is pivoted aside and that it can be separately removed after such pivoting. The control lead is fed out preferably through the ring so that it can be removed together with the anode/beam blanking unit and that ring.

In the embodiment shown in Fig. 2 the Wehnelt 2 is supplied in a cylinder, and is provided with a Wehnelt opening 55. The anode 3 comprises an anode holder 48, an anode plate 53 in which an anode opening 52 is provided. This anode and the beam blanking device are combined so as to form a mechanical integrated unity.

The anode holder 48 is connected to the Wehnelt cylinder 40 by means of an electrically insulating intermediate piece 46. The intermediate piece is formed, for example as a ceramic ring having an end face whereto the cylinder 40 is connected in a heat-resistant manner, for example by means of a clamp/screw connection. The anode holder 48 being secured to an oppositely situated end face of the intermediate piece in a similar manner. An integrated unit comprising Wehnelt cylinder, the anode and the beam blanking device is thus obtained. The openings in the Wehnelt as well as the anode are usually spherical, concentric with respect to the optical axis and have a diameter of, for example 0.5 mm. This method of mounting results in a suitably breakdown-resistant construction; if necessary, electrical creepage paths can be shifted by means of additional recesses in the insulating bush 46 so that no problems will be encountered with respect to creepage currents.

The entire unit thus formed can be connected for example in the described manner, to the base plate of the housing of the apparatus and be mounted so as to be removable or pivotable as one unit in the described manner. In the present embodiment the beam blanking device comprises, mounted in a bush 49, a set of electrostatic deflection plates 60 for deflection the beam. In order to be enabled to obtain a high blanking frequency the deflection plates 60 ought to be relatively small for instance 1 x 5 mm², a reason the more to have an exact positioning of the elements. At a side which is remote from the anode holder the bush 49 is closed by an aperture plate 62 which comprises an aperture 63 whereby the deflected beam can be intercepted and dissipated. The aperture plate can be exactly positioned by means of abutment faces 57 at the revelant end of the bush 49.

Notably in apparatus for measurements involving, for example, comparatively low anode voltages it is important to maintain a small but suitably defined distance between the Wehnelt cylinder and the anode as well as exact positioning of the anode and the beam blanking device with respect to one another in order to achieve suitable beam shaping. Using the described construction, distances of less than 1 mm can be readily achieved between the Wehnelt cylinder and the anode. When a more pronounced cup shape is imparted to the anode plate, the intermediate piece 46 can remain comparatively long so that the occurence of disturbing electric creepage currents will be avoided. For apparatus such as for integrated circuitry inspection in which such a circuitry or chip is scanned it is advantageous to operate with electrons having at the utmost an energy of about 1 KeV. The circuitry is not damaged by those electrons and due to the fact that the secondary emission coefficient of construction materials such as aluminium is nearly exactly 1 for this energy no electrical loading occurs making the operation still more reliable.

**Claims**

1. An electron beam apparatus comprising a cathode (1), a Wehnelt cylinder (2), an anode (3), a beam blanking device (4) and an electron optical system for modulation and alignment of an electron beam to be emitted by the cathode, characterized in that the cathode, the Wehnelt cylinder, the anode and the beam blanking device form a mechanically integrated electron optical unit.

2. An electron beam apparatus as claimed in Claim 1, characterized in that the electron optical unit comprises, accomodated in a bush (49), a set of electrostatic deflection plates (60), an exit diaphragm (62) with a bore (63) and an anode plate (53) which is provided with a bore (52).

3. An electron beam apparatus as claimed in Claim 1 or 2, characterized in that the electron optical unit forms a rigid assembly which is mounted in the electron beam apparatus so as to be removable as a unity.

4. An electron beam apparatus as claimed in any Claim 1, 2 or 3, characterized in that it is constructed for operation with high voltages of at the most a few kV.

5. An electron beam apparatus as claimed in Claim 4, characterized in that it is constructed for operation with high voltages of at the most about 1 KeV.

**Patentansprüche**

1. Elektronenstrahlgerät mit einer Kathode (1), einem Wehneltzylinder (2), einer Anode (3), einer Strahlaustasteinrichtung (4) und einem elektronen-optischen System zum Modulieren und Ausrichten eines von der Kathode auszusendenden Elektronenstrahls, dadurch gekennzeichnet, daß die Kathode, der Wehneltzylinder, die Anode und die Strahlaustasteinrichtung eine mechanisch integrierte elektronenoptische Einheit bilden.

2. Elektronenstrahlgerät nach Anspruch 1, dadurch gekennzeichnet, daß die elektronenoptische Einheit in einer Buchse (49) eine Anzahl elektrostatischer Ablenkplatten (60), eine Austrittsblende (62) mit einer Bohrung (63) und eine Anodenplatte (53) enthält, die mit einer Bohrung (52) versehen ist.

3. Elektronenstrahlgerät nach Anspruch 1 oder 2, dadurch gekennzeichnet, daß die elektronenoptische Einheit eine starre Montageeinrichtung bildet, die derart im Elektronenstrahlgerät montiert ist, daß sie als Einheit ausgenommen werden kann.

4. Elektronenstrahlgerät nach Anspruch 1, 2 oder 3, dadurch gekennzeichnet, daß es zum Betrieb mit Hochspannungen von höchstens wenigen kV ausgelegt ist.

5. Elektronenstrahlgerät nach Anspruch 4, dadurch gekennzeichnet, daß es zum Betrieb mit Hochspannungen von höchstens etwa 1 keV ausgelegt ist.

## Revendications

1. Appareil à faisceau d'électrons comprenant une cathode (1), un cylindre de Wehnelt (2), une anode (3), un dispositif d'occultation de faisceau (4) et un système optoélectronique pour la modulation et l'alignement d'un faisceau d'électrons à émettre par la cathode, caractérisé en ce que la cathode, le cylindre de Wehnelt, l'anode et le dispositif d'occultation de faisceau forment une unité optoélectronique intégrée mécaniquement.

2. Appareil à faisceau d'électrons suivant la revendication 1, caractérisé en ce que l'unité optoélectronique comprend, logé dans une douille (49), un jeu de plaques de déviation électrostatique (60), un diaphragme de sortie (62) percé d'une ouverture (63) et une plaque d'anode (53) qui est pourvue d'une ouverture (52).

3. Appareil à faisceau d'électrons suivant la revendication 1 ou 2, caractérisé en ce que l'unité optoélectronique forme un ensemble rigide qui est monté dans l'appareil à faisceau d'électrons de manière à pouvoir être retiré d'une seule pièce.

4. Appareil à faisceau d'électrons suivant l'une quelconque des revendications 1, 2 ou 3, caractérisé en ce qu'il est destiné à fonctionner avec des hautes tensions atteignant au maximum quelques kV.

5. Appareil à faisceau d'électrons suivant la revendication 4, caractérisé en ce qu'il est destiné à fonctionner avec des hautes tensions atteignant au maximum environ 1 kV.

FIG.1

FIG.2